# FASCICULE DE BREVET EUROPEEN

(11) **EP 2 890 937 B1**
(45) Date de publication et mention de la délivrance du brevet: **12.04.2017**
(21) Numéro de dépôt: 13759460.2
(22) Date de dépôt: 27.08.2013
(51) Int. Cl.: F24H 1/10, F24H 9/14, F24H 9/20, B60H 1/22, F24H 9/18, H05K 3/30, H05K 3/32

(54) **DISPOSITIF DE CHAUFFAGE ÉLECTRIQUE DE FLUIDE POUR VÉHICULE AUTOMOBILE**
ELEKTRISCHE HEIZVORRICHTUNG FÜR EINE FLÜSSIGKEIT FÜR EIN AUTOMOBILFAHRZEUG
ELECTRICAL HEATING DEVICE FOR A FLUID FOR AN AUTOMOBILE VEHICLE

(30) Priorité: 30.08.2012 FR 1202328
(43) Date de publication de la demande: 08.07.2015
(73) Titulaire: Valeo Systemes Thermiques, 78320 Le Mesnil Saint Denis (FR)
(72) Inventeur: PIERRON, Frédéric, F-78120 Rambouillet (FR); PUZENAT, Bertrand, F-78180 Montigny Le Bretonneux (FR); LEBORGNE, José, F-28600 Luisant (FR); TELLIER, Laurent, F-75116 Paris (FR)
(74) Mandataire: Metz, Gaëlle
(86) Numéro de dépôt international: PCT/EP2013/067698
(87) Numéro de publication internationale: WO 2014/033115

(56) Documents cités:
- EP-A1- 1 872 986
- WO-A1-01/94861
- WO-A1-2004/083738
- WO-A1-2005/064243
- WO-A1-2005/078867
- WO-A1-2007/039683
- WO-A2-2009/043865
- DE-A1- 19 902 050
- US-A1- 2011 235 348

## Description

L'invention concerne un dispositif de chauffage électrique de fluide pour véhicule automobile. L'invention s'applique plus particulièrement aux appareils de chauffage et/ou de climatisation de véhicules automobiles comportant un tel dispositif de chauffage.

Le document DE19902050 montre le préambule de la revendication 1. De façon habituelle, le réchauffage de l'air destiné au chauffage de l'habitacle d'un véhicule automobile, ainsi qu'au désembuage et au dégivrage, est assuré par le passage d'un flux d'air à travers un échangeur de chaleur, plus précisément par un échange de chaleur entre le flux d'air et un fluide. Il s'agit généralement du fluide de refroidissement dans le cas d'un moteur thermique. Toutefois, ce mode de chauffage peut s'avérer inadapté ou insuffisant pour garantir un chauffage rapide et efficace de l'habitacle du véhicule, en particulier pour assurer un réchauffement de l'habitacle ou dégivrage ou désembuage avant utilisation du véhicule en environnement très froid ou encore lorsqu'une montée très rapide de la température est souhaitée.

En outre, dans le cas d'un véhicule électrique, la fonction de chauffage n'est plus réalisée par la circulation du fluide de refroidissement dans l'échangeur de chaleur. On peut cependant prévoir un circuit d'eau pour le chauffage de l'habitacle mais ce mode de chauffage peut aussi s'avérer inadapté ou insuffisant pour garantir un chauffage rapide et efficace de l'habitacle du véhicule.

En outre, afin de réduire l'encombrement et le coût du fait du circuit d'eau supplémentaire, il est également connu d'utiliser pour le véhicule électrique, une boucle de climatisation fonctionnant en mode pompe à chaleur. Ainsi, la boucle de climatisation permettant classiquement de refroidir un flux d'air à l'aide d'un fluide réfrigérant est dans ce cas, utilisée de façon à réchauffer le flux d'air. Il convient pour ce faire d'utiliser un évaporateur de la boucle de climatisation comme un condenseur. Toutefois, ce mode de chauffage aussi peut s'avérer inadapté ou insuffisant. En effet, les performances de la boucle de climatisation en mode pompe à chaleur dépendent des conditions climatiques extérieures; et en cas d'air extérieur avec une température trop basse, cet air ne peut pas être utilisé comme source d'énergie thermique.

Une solution connue consiste à adjoindre à l'échangeur de chaleur ou au circuit d'eau ou encore à la boucle de climatisation, un dispositif de chauffage électrique additionnel. Le dispositif de chauffage électrique additionnel peut être adapté pour chauffer en amont le fluide, tel que le fluide de refroidissement pour le moteur thermique, ou l'eau du circuit d'eau de chauffage de l'habitacle du véhicule électrique ou encore le fluide réfrigérant de la boucle de climatisation.

Pour cela, le dispositif de chauffage électrique additionnel comporte un élément chauffant en contact avec le fluide à chauffer et un moyen de commande pourvu d'un capteur de température pour le contrôle en température de l'élément chauffant.

Un des buts de la présente invention est de proposer un dispositif de chauffage électrique de fluide de véhicule automobile dont le raccord entre l'élément chauffant et le module de commande soit à la fois simple, compact et robuste.

À cet effet, l'invention a pour objet un dispositif de chauffage électrique de fluide pour véhicule selon la revendication 1.

Le dispositif de chauffage électrique peut en outre comporter une ou plusieurs caractéristiques suivantes, prises séparément ou en combinaison :
- le moyen de maintien mécanique est amovible; il est donc simple à assembler,
- le connecteur électrique comporte un premier connecteur électriquement raccordé à l'élément chauffant et un deuxième connecteur électriquement raccordé au support de carte de circuit électrique,
- le moyen de maintien mécanique est formé par coopération mécanique entre le premier et le deuxième connecteurs; il est donc simple à assembler,
- le premier et le deuxième connecteurs sont enfichables l'un dans l'autre ; ce qui permet de sécuriser la liaison électrique,
- le connecteur électrique présente des lames élastiques de contactage configurées pour contacter des pistes électriques de l'élément chauffant,
- le dispositif de chauffage comprend un boîtier d'entrée de fluide et un boîtier de sortie de fluide et le moyen de maintien mécanique étant formé par l'assemblage des boîtiers d'entrée et de sortie de fluide avec l'élément chauffant et le support de carte électrique, ce qui permet de s'affranchir d'une pièce intermédiaire,
- le connecteur électrique présente une surface de connexion épousant sensiblement partiellement le pourtour de l'élément chauffant,
- l'élément chauffant est sensiblement cylindrique et en ce que le pourtour de l'élément chauffant est sensiblement cylindrique,
- le dispositif de chauffage comporte deux éléments chauffants et le moyen de raccord comporte un unique connecteur électrique, ce qui permet de réduire les coûts de fabrication,
- les éléments chauffants sont sensiblement cylindriques,
- les éléments chauffants sont disposés côte à côte,
- le connecteur électrique présente une surface de connexion épousant sensiblement partiellement le pourtour cylindrique du premier élément chauffant et partiellement le pourtour cylindrique du deuxième élément chauffant, ledit connecteur électrique s'étendant entre lesdits éléments chauffants,
- le support de carte de circuit électrique est traversé par des contacts électriques du connecteur électrique,
- les contacts électriques sont fixés sur une face du support de circuit électrique opposée à celle en vis-à-vis de l'élément chauffant,
- le moyen de maintien mécanique comporte des clips de verrouillage coopérant par déformation élastique avec le support de circuit électrique pour assurer le contact électrique entre les contacts électriques et le support de circuit électrique ; le moyen de maintien mécanique assure ainsi le contact électrique entre les contacts électriques et le support de circuit électrique ; de plus le connecteur électrique n'est pas limité par la densité de courant apte à le parcourir,
- le support de carte électrique présente des orifices munis de plages de contactage et en ce que les contacts électriques comportent des pines élastiques frettées dans lesdits orifices du support de carte électrique, la coopération des pines élastiques dans les orifices formant un moyen de maintien mécanique.

D'autres caractéristiques et avantages de l'invention apparaîtront plus clairement à la lecture de la description suivante, donnée à titre d'exemple illustratif et non limitatif, et des dessins annexés parmi lesquels :
- la figure 1 représente une vue en perspective d'un dispositif de chauffage électrique de fluide pour véhicule automobile selon un exemple de réalisation de la présente invention, partiellement représenté en transparence,
- la figure 2 représente le dispositif de chauffage électrique de la figure 1 représenté en plein auquel on a ôté un boîtier de sortie de fluide,
- la figure 3 représente une vue arrière du dispositif de chauffage de la figure 2 selon un premier mode de réalisation,
- la figure 4 représente une vue schématique et simplifiée d'éléments du dispositif de chauffage de la figure 1,
- la figure 5 est une vue schématique et simplifiée d'éléments du dispositif de chauffage de la figure 4, vue en coupe selon un plan radial au module de chauffe,
- la figure 6a représente un contact électrique à l'aplomb d'un orifice de support de carte électrique d'un dispositif de chauffage selon un exemple de réalisation,
- la figure 6b représente le contact électrique de la figure 6a inséré dans ledit orifice,
- la figure 7 représente une vue arrière d'éléments d'un dispositif de chauffage selon un deuxième mode de réalisation de la présente invention,
- la figure 8 représente une vue de côté du dispositif de chauffage de la figure 7,
- la figure 9 représente une vue schématique et simplifiée d'éléments du dispositif de chauffage de la figure 8, vue en coupe selon un plan radial au module de chauffe,
- la figure 10 représente une vue schématique de côté d'un troisième mode de réalisation du dispositif de chauffage,
- la figure 11 est une vue schématique et simplifiée d'éléments du dispositif de chauffage de la figure 10, vue en coupe selon un plan radial au module de chauffe,
- la figure 12 représente une vue schématique d'éléments d'un connecteur électrique du dispositif de chauffage de la figure 10,
- la figure 13 représente une vue arrière d'éléments d'un dispositif de chauffage selon un quatrième mode de réalisation,
- la figure 14 représente une vue schématique et simplifiée du dispositif de chauffage de la figure 13, vue en coupe selon un plan sensiblement médian, et
- la figure 15 représente une vue schématique et simplifiée d'éléments du dispositif de chauffage de la figure 13, vue en coupe selon un plan radial au module de chauffe.

Dans ces figures, les éléments sensiblement identiques portent les mêmes références.

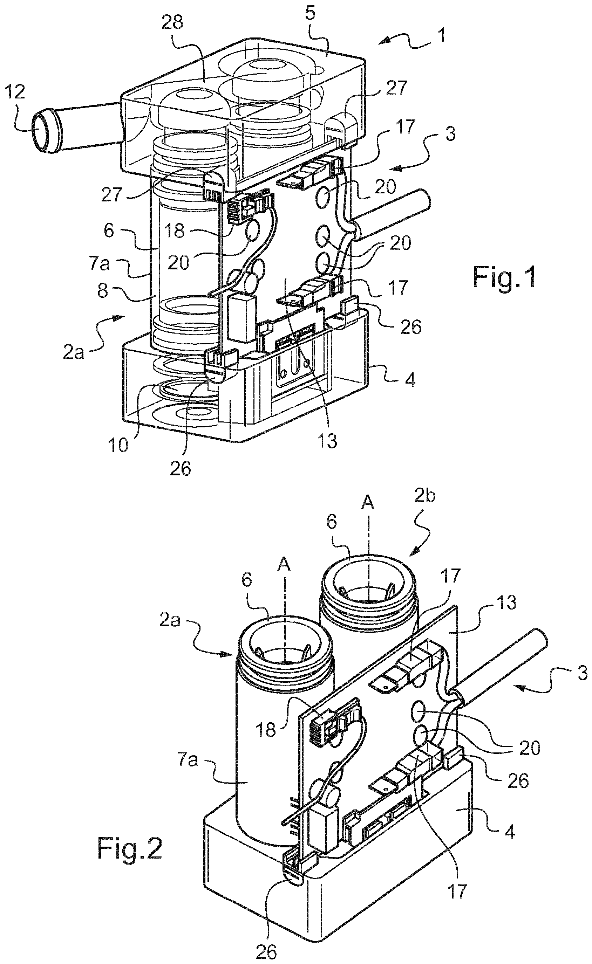

La figure 1 représente un dispositif de chauffage électrique de fluide 1 pour véhicule automobile pour un appareil de chauffage et/ou climatisation.

Le dispositif de chauffage électrique 1 est par exemple un dispositif de chauffage additionnel permettant de chauffer un fluide avant son entrée dans un circuit de chauffage d'eau pour le chauffage de l'habitacle d'un véhicule électrique. Selon un autre exemple, le dispositif de chauffage électrique 1 est disposé en amont d'un évaporateur d'une boucle de climatisation apte à fonctionner en mode pompe à chaleur, de façon à chauffer le fluide réfrigérant. Selon encore un autre exemple, le dispositif de chauffage électrique 1 est agencé en amont d'un échangeur de chaleur utilisant le fluide de refroidissement d'un moteur thermique comme fluide caloporteur. On pourrait aussi prévoir un tel dispositif de chauffage électrique 1 en amont d'un échangeur de chaleur destiné à la régulation thermique d'un dispositif de stockage de l'énergie électrique, parfois qualifié d'ensemble de batteries, pour un véhicule à propulsion électrique ou hybride.

Le dispositif de chauffage électrique 1 représenté comprend un premier et un deuxième modules de chauffe 2a, 2b, un moyen de commande 3, un boîtier d'entrée de fluide 4 et un boîtier de sortie de fluide 5.

Chaque module de chauffe 2a, 2b comporte un noyau central 6, par exemple creux, et un élément chauffant 7a, 7b réalisé sous la forme d'une enveloppe cylindrique entourant le noyau central 6 de manière à définir un circuit de guidage 8 du fluide à chauffer entre la surface externe du noyau central 6 et la surface interne de l'enveloppe de l'élément chauffant 7a, 7b.

Selon l'exemple de réalisation considéré, l'élément chauffant 7a, 7b est cylindrique. Toutefois, celui-ci peut être réalisé selon une forme différente. En effet, il peut être réalisé sous forme de plaque, de tube, de cône ou tronc de cône ou toute forme géométrique, le noyau étant alors adapté à ces formes.

L'élément chauffant 7a, 7b comprend sur sa surface externe, c'est-à-dire sur la surface opposée à celle en regard du noyau central, une résistance chauffante, notamment une résistance chauffante sérigraphiée.

Le circuit de guidage 8 est le volume situé entre la surface externe du noyau central 6 et la surface interne de l'enveloppe de l'élément chauffant 7a, 7b dans lequel le fluide peut circuler depuis le boîtier d'entrée de fluide 4 vers le boîtier de sortie de fluide 5.

Les modules de chauffe 2a, 2b présentent une forme générale sensiblement cylindrique définie par l'enveloppe de l'élément chauffant 7a, 7b. Le circuit de guidage 8 présente ainsi une forme annulaire s'étendant selon l'axe longitudinal A du noyau central 6 et de l'élément chauffant 7a, 7b, de sorte que l'écoulement du fluide soit guidé sensiblement parallèlement à l'axe longitudinal A , comme cela est représenté à la figure 1.

Les modules de chauffe 2a, 2b sont identiques et sont disposés côte à côte de façon sensiblement parallèle. Cette disposition côte à côte permet de réduire l'encombrement du dispositif de chauffage 1 dans le sens longitudinal. De plus, cet agencement présente une faible inertie de chauffe et une faible perte de charge.

Un canal d'entrée 10 du fluide est formé dans le boîtier d'entrée de fluide 4. Le canal d'entrée 10 communique avec le circuit de guidage 8 du premier module de chauffe 2a et avec le circuit de guidage 8 du deuxième module de chauffe 2b.

Le boîtier d'entrée de fluide 4 présente ainsi une base sensiblement parallélépipédique recevant les extrémités d'entrée respectives des modules de chauffe 2a, 2b. Le boîtier d'entrée de fluide 4 comporte également une tubulure saillante d'admission 11 du dispositif 1.

Le canal d'entrée 10 est un passage pour le fluide formé dans le boîtier d'entrée de fluide 4 entre la tubulure saillante d'admission 11 et au moins un circuit de guidage 8. Le canal d'entrée 10 raccorde ainsi fluidiquement la tubulure d'admission de fluide 11 en parallèle aux deux cavités.

De même, un canal de sortie 28 pour le passage du fluide est formé dans le boîtier de sortie de fluide 5 entre au moins un circuit de guidage 8 et la tubulure saillante de sortie du dispositif 1. Dans l'exemple, le canal de sortie 28 communique avec le circuit de guidage 8 du premier module de chauffe 2a et avec le circuit de guidage 8 du deuxième module de chauffe 2b. Les boîtiers de sortie et d'entrée 5, 4 sont ainsi raccordés symétriquement, aux deux extrémités opposées des modules de chauffe 7a, 7b.

L'écoulement du fluide s'effectue ainsi depuis la tubulure d'admission de fluide 11, dans le canal d'entrée 10, puis en parallèle dans les circuits de guidage 8 des modules de chauffe 2a, 2b et ressort dans le canal de sortie 28.

Le moyen de commande 3 des éléments chauffants 7a, 7b comporte un support de circuit électrique 13 et un capteur de température (non représenté) associé à chaque élément chauffant 7a, 7b.

Les capteurs de température sont configurés pour mesurer la température d'un élément chauffant respectif 7a, 7b.

Les capteurs de température comportent par exemple une thermistance, telle que qu'une « CTN » (Coefficient de Température Négatif, en anglais « NTC » pour « Negative Temperature Coefficient ») dont la résistance diminue de façon uniforme avec la température. Le capteur de température est par exemple brasé ou soudé sur la surface externe de l'élément chauffant respectif 7a, 7b, c'est-à-dire hors du circuit de guidage 8.

Le moyen de commande 3 contrôle les éléments chauffants 7a et 7b en contrôlant l'alimentation d'une résistance chauffante, par exemple sérigraphiée sur la surface externe de chaque élément chauffant 7a, 7b, en fonction d'une consigne de chauffage et de la température mesurée par le capteur de température respectif. Le fluide est ainsi chauffé par échange de chaleur entre chaque élément chauffant 7a, 7b et le fluide circulant dans le circuit de guidage 8.

Le support de circuit électrique 13, tel qu'une carte à circuit imprimé (ou PCB en anglais pour "Printed circuit board"), porte les composants électroniques et/ou électriques. Ces composants électroniques et/ou électriques peuvent par exemple comporter un microcontrôleur, un ou des interrupteurs de courant électrique pour contrôler l'alimentation électrique des éléments chauffants 7a, 7b, des pistes électriques reliant les éléments de chauffage 7a, 7b aux interrupteurs de courant électriques, des connecteurs d'alimentation haute tension 17 et un connecteur d'alimentation basse tension et de bus de données 18, comme il est illustré à la figure 2 par exemple.

Le dispositif de chauffage 1 comporte en outre un moyen de raccord comprenant un connecteur électrique raccordant électriquement l'élément chauffant 7a, 7b au support de carte électrique 13. Le moyen de raccord peut comprendre au moins un moyen de maintien mécanique configuré pour maintenir mécaniquement ledit connecteur électrique contre l'élément chauffant 7a, 7b.

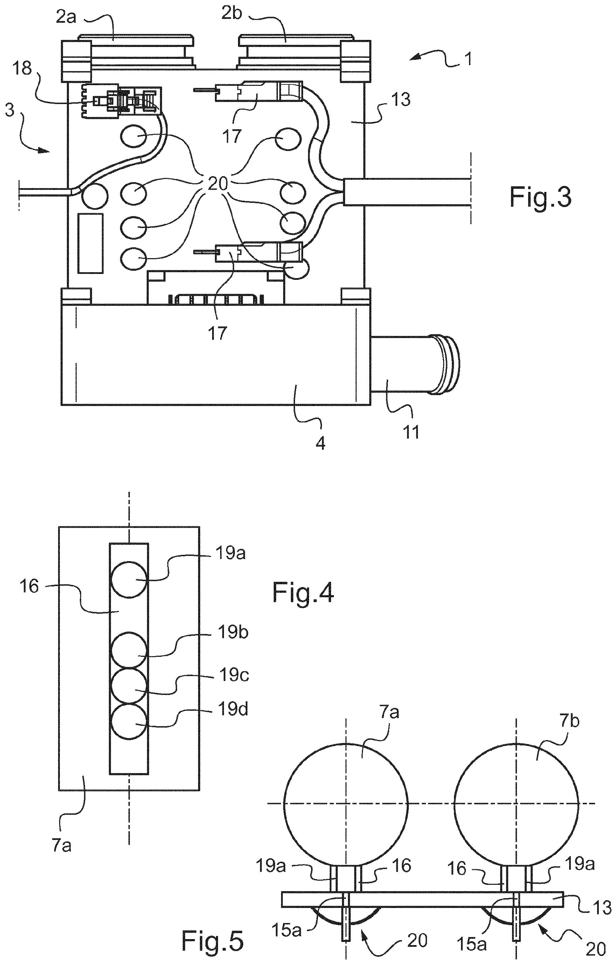

Selon un premier mode de réalisation représenté sur les figures 3 à 5, le moyen de raccord comporte deux connecteurs électriques 16 comprenant des contacts électriques 19a, 19b, 19c, 19d.

Les contacts électriques 19a, 19b, 19c, 19d sont électriquement reliés d'une part à l'élément chauffant 7a, 7b associé et d'autre part au support de carte électrique 13. Plus précisément, les connecteurs électriques 16 comportent quatre contacts électriques 19a, 19b, 19c 19d dont deux sont reliés au capteur de température de chaque élément chauffant 7a, 7b, par exemple par des pistes électriques sérigraphiées sur chaque élément chauffant 7a, 7b, pour la mesure de la température, et dont deux sont dédiés à l'alimentation de la résistance chauffante de l'élément chauffant 7a, 7b.

Les quatre contacts électriques 19a, 19b, 19c, 19d sont par exemple alignés sur une génératrice de la surface du tube de l'élément chauffant 7a, 7b.

Les connecteurs électriques 16 présentent une forme quelconque, par exemple parallélépipédique ou épousent au moins partiellement la forme de l'élément chauffant 7a, 7b, et sont interposés entre un élément chauffant 7a, 7b respectif et le support de carte électrique 13.

Le corps du connecteur électrique 16 est en matériau électriquement isolant. Il comporte par exemple un matériau thermoplastique, tel que du type PBT GF (tel que le PBT GF 10), qui est doté d'une rigidité et d'une résistance mécanique très élevées et qui possède d'excellentes propriétés d'isolation électrique.

Les contacts électriques 19a, 19b, 19c, 19d sont par exemple soudés ou brasés aux pistes de l'élément chauffant 7a, 7b par exemple par un procédé de refusion.

Le support de carte de circuit électrique 13 est traversé par les contacts électriques 19a, 19b, 19c, 19d de chaque connecteur électrique 16.

Selon un premier mode de réalisation illustré sur les figures 1 à 5, les contacts électriques 19a, 19b, 19c, 19d sont insérés dans des orifices associés 15a, 15b, 15c, 15d ménagés dans le support de carte de circuit électrique 13 et sont fixés sur une face du support de circuit électrique 13 opposée à celle en vis-à-vis de l'élément chauffant 7a, 7b. En outre, la connexion électrique entre chaque élément chauffant 7a, 7b et le support de carte de circuit électrique 13 est assurée notamment par le maintien mécanique du contact entre le connecteur électrique de chaque élément chauffant 7a, 7b et du support de carte de circuit électrique 13 par un moyen de maintien mécanique.

Le moyen de maintien mécanique peut comporter par exemple des clips de verrouillage 20 coopérant par déformation élastique avec le support de circuit électrique 13 pour maintenir les contacts électriques 19a, 19b, 19c, 19d contre le support de circuit électrique 13.

Les clips de verrouillage 20 se fixent à l'arrière du support de circuit électrique 13, c'est-à-dire sur une face du support de circuit électrique 13 opposée à celle en vis-à-vis de l'élément chauffant 7a, 7b. Les clips de verrouillage 20 permettent de plaquer et de solidariser les contacts électriques 19a, 19b, 19c, 19d aux plages de contactage du support de circuit électrique 13. Le moyen de maintien mécanique assure ainsi le contact électrique entre les contacts électriques 19a, 19b, 19c, 19d et le support de circuit électrique 13.

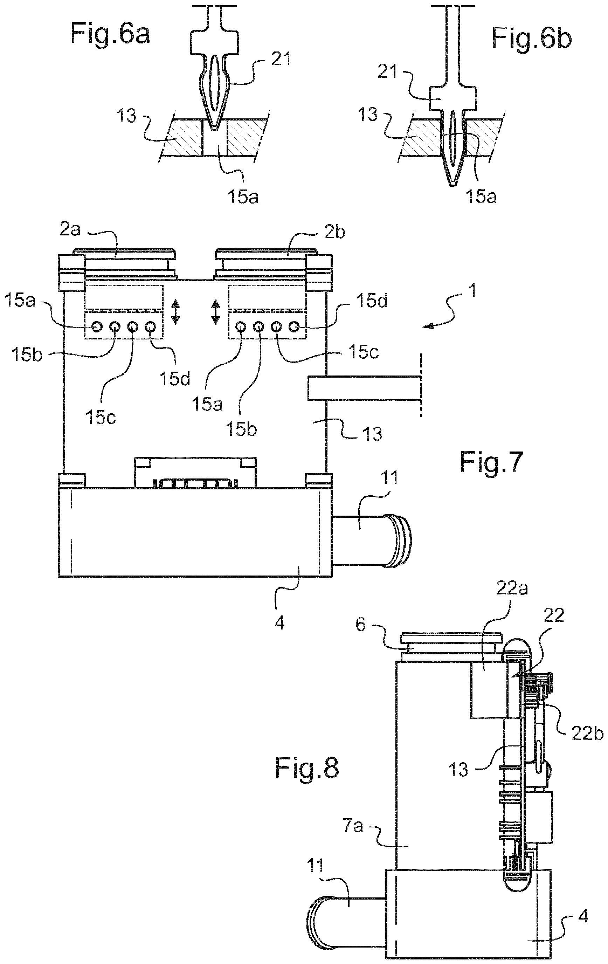

Selon un exemple du premier mode de réalisation représentée sur les figures 6a et 6b, les parois des orifices 15a, 15b, 15c, 15d sont munies de plages de contactage et les contacts électriques 19a, 19b, 19c, 19d comportent des pines élastiques 21 frettées dans lesdits orifices 15a, 15b, 15c, 15d. Les pines élastiques 21 sont montées en force dans les orifices 15a, 15b, 15c, 15d, ce qui forme un moyen de maintien mécanique et assure le raccord électrique des éléments chauffants 7a, 7b au support de carte électrique 13.

En proposant que le raccord électrique de l'élément chauffant 7a, 7b soit maintenu contre le support de carte électrique 13 par coopération mécanique, on peut assembler l'élément chauffant 7a, 7b au support de carte électrique 13, mécaniquement et électriquement par un moyen unique et compatible avec les lignes de production respective.

En effet, ce moyen permet que le support de carte électrique soit fabriqué sur une ligne de production se référant à la technologie électrique/électronique, distincte de celle des éléments chauffants. Le raccordement entre ces deux éléments est ainsi réalisé postérieurement à leur fabrication, ce qui permet de conserver les lignes de production préalables propres à chacun des composants du dispositif de chauffage 1. Le raccord électrique et mécanique du dispositif de chauffage est ainsi réalisé de manière simple et fiable. En outre, la robustesse et la compacité du dispositif de chauffage sont améliorés.

Le premier mode de réalisation présente l'avantage que le moyen de raccord est simple à mettre en oeuvre et facile à assembler. Ledit moyen de raccord peut être amovible. Le moyen de raccord comprenant au moins un clip de verrouillage 20 présente l'avantage supplémentaire que le connecteur électrique n'est pas être limité par la densité de courant apte à le parcourir.

Selon un deuxième mode de réalisation représenté sur les figures 7, 8 et 9, le moyen de raccord comporte deux premiers connecteurs 22a électriquement raccordés à un élément chauffant respectif 7a, 7b et deux deuxièmes connecteurs 22b électriquement raccordés au support de carte de circuit électrique 13.

Le moyen de maintien mécanique est formé par coopération mécanique entre le premier et le deuxième connecteurs 22a, 22b. Par exemple, le premier et le deuxième connecteurs 22a, 22b sont enfichables l'un dans l'autre, c'est-à-dire qu'ils se raccordent ensemble par emboîtement de type mâle/femelle.

Les premiers connecteurs 22a peuvent en outre présenter une surface de connexion épousant sensiblement partiellement le pourtour cylindrique des éléments chauffants respectifs 7a, 7b.

Les premiers connecteurs 22a sont par exemple soudés ou brasés à l'élément chauffant 7a, 7b par un procédé de refusion.

Les contacts électriques 19a, 19b, 19c, 19d des deuxièmes connecteurs 22b sont fixés à des plages de contactage du support de circuit électrique 13 par exemple par des pines élastiques 21 frettées dans des orifices du support de carte électrique 13. Il est également envisageable de fixer les contacts électriques 19a, 19b, 19c, 19d au support de carte électrique 13 par soudure.

Ce deuxième mode de réalisation du moyen de raccord présente l'avantage d'être facile à assembler, de ne pas être limité par la densité de courant pouvant le traverser. En outre, le moyen de maintien mécanique par le système enfichable permet de sécuriser la liaison électrique et il est amovible.

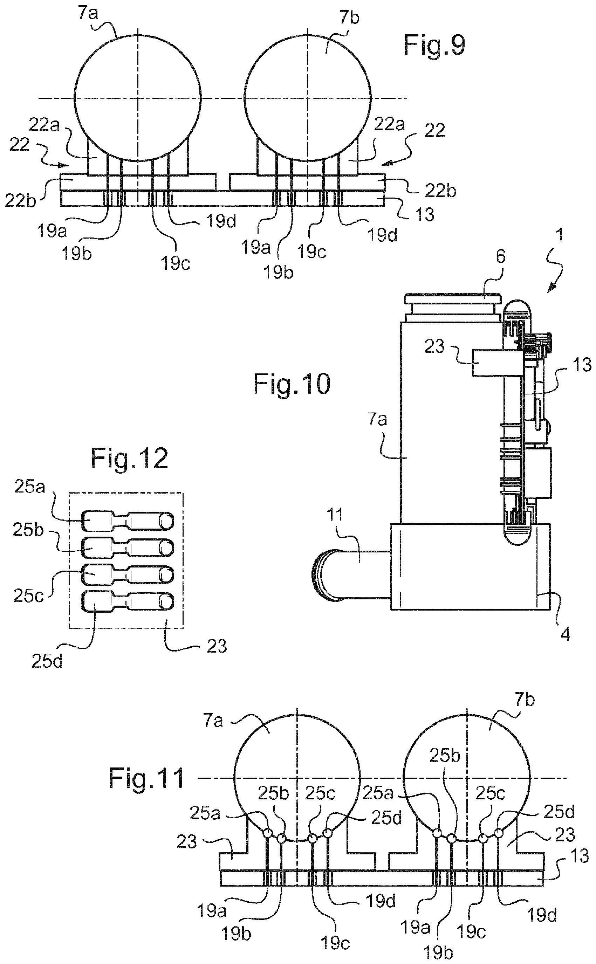

Selon un troisième mode de réalisation représentée sur les figures 10, 11 et 12, le moyen de raccord comporte deux connecteurs électriques 23, chacun réalisé d'une seule pièce.

Le connecteur électrique 23 comporte par exemple quatre lames élastiques de contactage 25a, 25b, 25c, 25d (figure 12) agencées sur une surface de connexion pour contacter les pistes électriques de l'élément chauffant 7a, 7b.

Les lames élastiques de contactage 25a, 25b, 25c, 25d présentent une extrémité fixée au corps du connecteur électrique 23 et une extrémité libre, souple destinée à venir en appui contre l'élément chauffant 7a, 7b.

L'assemblage des boîtiers d'entrée et de sortie de fluide 4, 5 avec les éléments chauffants 7a, 7b et le support de carte électrique 13 permet de maintenir mécaniquement les lames élastiques de contactage 25a, 25b, 25c, 25d contre les pistes des éléments chauffants 7a, 7b.

Comme illustré à la figure 1, pour faciliter l'assemblage, on peut prévoir que le boîtier d'entrée de fluide 4 comporte un premier moyen de positionnement 26 du support de circuit électrique 13 et que le boîtier de sortie de fluide 5 présente un deuxième moyen de positionnement 27 du support de circuit électrique 13. Le premier moyen de positionnement 26 comporte par exemple deux clips fixés au corps du boîtier d'entrée de fluide 4 qui fixent de manière amovible le support de circuit électrique 13. De même, le deuxième moyen de positionnement 27 comporte par exemple deux clips fixés au corps du boîtier de sortie de fluide 5 qui fixent de manière amovible le support de circuit électrique 13. Les quatre clips pincent le support de circuit électrique 13 aux quatre coins.

En outre et comme on peut le voir sur la figure 11, le connecteur électrique 23 peut présenter une surface de connexion épousant sensiblement partiellement le pourtour cylindrique de l'élément chauffant respectif 7a, 7b.

Au niveau du support de carte électrique 13, les contacts électriques 19a, 19b, 19c, 19 des connecteurs électriques 23 sont fixés à des plages de contactage du support de circuit électrique 13 par exemple par des pines élastiques 21 frettées dans des orifices du support de carte électrique 13. Il est également envisageable de fixer les contacts électriques 19a, 19b, 19c, 19d au support de carte électrique 13 par soudure.

Ce troisième mode de réalisation permet de s'affranchir d'une pièce intermédiaire. En outre, le moyen de maintien mécanique est amovible.

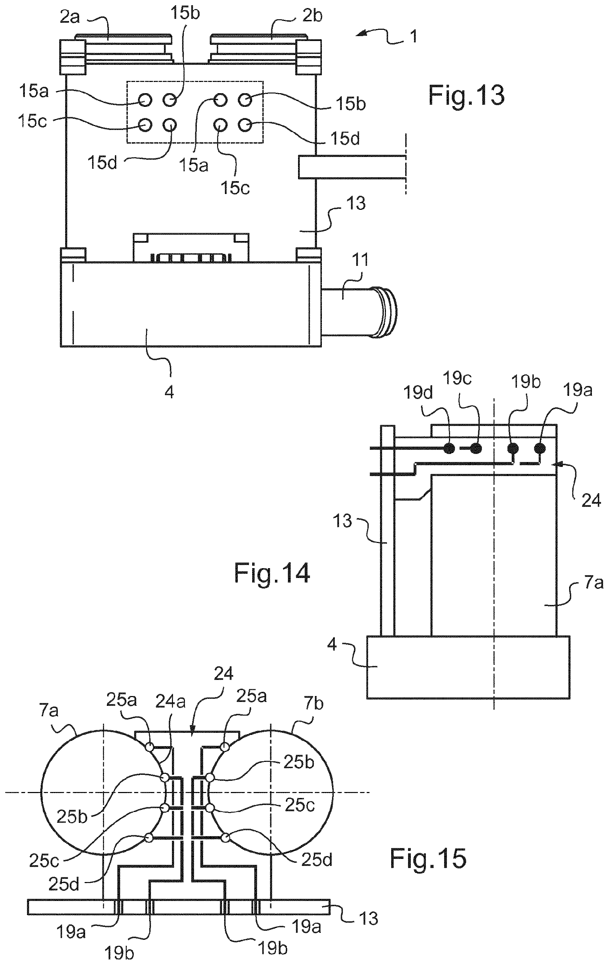

Selon un quatrième mode de réalisation représenté sur les figures 13, 14 et 15, le moyen de raccord comporte un unique connecteur électrique 24. L'utilisation d'un connecteur électrique unique permet de réduire les coûts de fabrication.

Le connecteur électrique 24 présente une surface de connexion 24a épousant sensiblement partiellement le pourtour cylindrique du premier élément chauffant 7a et partiellement le pourtour cylindrique du deuxième élément chauffant 7b, le connecteur électrique 24 s'étendant entre les éléments chauffants 7a, 7b.

Le connecteur électrique 24 est ainsi traversé par, par exemple, huit contacts électriques (dont seulement quatre sont visibles sur la figure 15).

Comme dans le troisième mode de réalisation, le connecteur électrique 24 peut comporter des lames élastiques de contactage 25a, 25b, 25c, 25d agencées sur la surface de connexion 24a pour assurer le contact électrique avec les pistes électriques des éléments chauffants respectifs 7a, 7b.

L'assemblage des boîtiers d'entrée et de sortie de fluide 4, 5 avec les éléments chauffants 7a, 7b et le support de carte électrique 13 permet de maintenir mécaniquement les lames élastiques de contactage 25a, 25b, 25c, 25d contre les pistes des éléments chauffants 7a, 7b.

Au niveau du support de carte électrique 13, les contacts électriques 19a, 19b, 19c, 19d du connecteur électrique 24 sont fixés à des plages de contactage du support de circuit électrique 13 par exemple par des pines élastiques 21 frettées dans des orifices du support de carte électrique 13. Il est également envisageable de fixer les contacts électriques 19a, 19b, 19c, 19d au support de carte électrique 13 par soudure.

Bien que le mode de réalisation qui vient d'être décrit comporte deux modules de chauffe 2a, 2b, le dispositif de chauffage peut comporter un ou plus de deux éléments chauffants et un unique connecteur électrique épousant partiellement le pourtour de chaque élément chauffant.

On comprend que le moyen de raccord électrique et le moyen de raccord mécanique du dispositif de chauffage sont réalisés de manière simple et fiable. En outre, la robustesse et la compacité du dispositif de chauffage sont améliorées.

## Revendications

1. Dispositif de chauffage électrique de fluide pour véhicule automobile, **caractérisé en ce qu'**il comporte:
- au moins un élément chauffant (7a, 7b),
- un moyen de commande (3) de l'élément chauffant (7a, 7b) comportant un support de carte électrique (13), et
- un moyen de raccord comportant :
- un connecteur électrique (22; 16; 23; 24) raccordant électriquement l'élément chauffant (7a, 7b) au support de carte électrique (13), et
- au moins un moyen de maintien mécanique configuré pour maintenir mécaniquement ledit connecteur électrique (22 ; 16 ; 23, 24) contre l'élément chauffant (7a, 7b),
**caractérisé en ce que** ledit au moins un élément chauffant (7a, 7b) comprend sur sa surface externe une résistance chauffante.

2. Dispositif de chauffage selon la revendication 1, **caractérisé en ce que** le moyen de maintien mécanique est amovible.

3. Dispositif de chauffage selon l'une des revendications 1 ou 2, **caractérisé en ce que** le connecteur électrique (22) comporte un premier connecteur (22a) électriquement raccordé à l'élément chauffant (7a, 7b) et un deuxième connecteur (22b) électriquement raccordé au support de carte de circuit électrique (13) et **en ce que** le moyen de maintien mécanique est formé par coopération mécanique entre le premier et le deuxième connecteurs (22a, 22b).

4. Dispositif de chauffage selon la revendication 3, **caractérisé en ce que** le premier et le deuxième connecteurs sont enfichables l'un dans l'autre.

5. Dispositif de chauffage selon l'une des revendications 1 ou 2, **caractérisé en ce que** le connecteur électrique (22b, 23) présente des lames élastiques de contactage configurées pour contacter des pistes électriques de l'élément chauffant (7a, 7b), et **en ce que** le dispositif de chauffage comprend un boîtier d'entrée de fluide (4) et un boîtier de sortie de fluide (5) et le moyen de maintien mécanique étant formé par l'assemblage des boîtiers d'entrée et de sortie de fluide (4, 5) avec l'élément chauffant (7a, 7b) et le support de carte électrique (13).

6. Dispositif de chauffage selon l'une quelconque des revendications 1 à 5, **caractérisé en ce que** le connecteur électrique (22b ; 23) présente une surface de connexion épousant sensiblement partiellement le pourtour de l'élément chauffant (7a, 7b).

7. Dispositif de chauffage selon la revendication 6, **caractérisé en ce que** l'élément chauffant (7a, 7b) est sensiblement cylindrique et **en ce que** le pourtour de l'élément chauffant (7a, 7b) est sensiblement cylindrique.

8. Dispositif de chauffage selon la revendication 1 ou 2 ou selon l'une quelconque des revendications 5 à 7, **caractérisé en ce qu'**il comporte deux éléments chauffants (7a, 7b) et **en ce que** le moyen de raccord comporte un unique connecteur électrique (24).

9. Dispositif de chauffage selon la revendication 8, **caractérisé en ce que** les éléments chauffants (7a, 7b) sont sensiblement cylindriques et sont disposés côte à côte et **en ce que** le connecteur électrique (24) présente une surface de connexion (24a) épousant sensiblement partiellement le pourtour cylindrique du premier élément chauffant (7a) et partiellement le pourtour cylindrique du deuxième élément chauffant (7b), ledit connecteur électrique (24) s'étendant entre lesdits éléments chauffants (7a, 7b).

10. Dispositif de chauffage selon l'une quelconque des revendications 1 à 9, **caractérisé en ce que** le support de carte de circuit électrique (13) est traversé par des contacts électriques (19a, 19b, 19c, 19d) du connecteur électrique (16).

11. Dispositif de chauffage selon la revendication 10, **caractérisé en ce que** les contacts électriques (19a, 19b, 19c, 19d) sont fixés sur une face du support de circuit électrique (13) opposée à celle en vis-à-vis de l'élément chauffant (7a, 7b).

12. Dispositif de chauffage selon la revendication 11, **caractérisé en ce que** le moyen de maintien mécanique comporte des clips de verrouillage (20) coopérant par déformation élastique avec le support de circuit électrique (13) pour assurer le contact électrique entre les contacts électriques (19a, 19b, 19c, 19d) et le support de circuit électrique (13).

13. Dispositif de chauffage selon la revendication 10, **caractérisé en ce que** le support de carte électrique (13) présentent des orifices (15a, 15b, 15c, 15d) munis de plages de contactage et **en ce que** les contacts électriques (19a, 19b, 19c, 19d) comportent des pines élastiques (21) frettées dans lesdits orifices (15a, 15b, 15c, 15d) du support de carte électrique (13), la coopération des pines élastiques (21) dans les orifices (15a, 15b, 15c, 15d) formant un moyen de maintien mécanique.

## Patentansprüche

1. Elektrische Heizvorrichtung für eine Flüssigkeit für ein Kraftfahrzeug, **dadurch gekennzeichnet, dass** sie umfasst:
- mindestens ein Heizelement (7a, 7b),
- ein Steuermittel (3) für das Heizelement (7a, 7b), umfassend einen Träger einer elektrischen Karte (13), und
- ein Anschlussmittel, umfassend:
- einen elektrischen Verbinder (22; 16; 23; 24), der das Heizelement (7a, 7b) elektrisch an den Träger einer elektrischen Karte (13) anschließt, und
- mindestens ein mechanisches Haltemittel, das dazu vorgesehen ist, den elektrischen Verbinder (22; 16; 23, 24) gegen das Heizelement (7a, 7b) zu halten,
**dadurch gekennzeichnet, dass** das mindestens eine Heizelement (7a, 7b) auf seiner Außenseite einen Heizwiderstand umfasst.

2. Heizvorrichtung nach Anspruch 1, **dadurch gekennzeichnet, dass** das mechanische Haltemittel abnehmbar ist.

3. Heizvorrichtung nach einem der Ansprüche 1 oder 2, **dadurch gekennzeichnet, dass** der elektrische Verbinder (22) einen ersten Verbinder (22a), der elektrisch an das Heizelement (7a, 7b) angeschlossen ist, und einen zweiten Verbinder (22b) umfasst, der elektrisch an den Träger einer Karte einer elektrischen Schaltung (13) angeschlossen ist, und dass das mechanische Haltemittel durch mechanisches Zusammenwirken zwischen dem ersten und dem zweiten Verbinder (22a, 22b) gebildet ist.

4. Heizvorrichtung nach Anspruch 3, **dadurch gekennzeichnet, dass** der erste und der zweite Verbinder ineinander einsteckbar sind.

5. Heizvorrichtung nach einem der Ansprüche 1 oder 2, **dadurch gekennzeichnet, dass** der elektrische Verbinder (22b, 23) elastische Kontaktlamellen aufweist, die dazu vorgesehen sind, mit elektrischen Spuren des Heizelements (7a, 7b) in Kontakt zu kommen, und dass die Heizvorrichtung ein Eintrittsgehäuse einer Flüssigkeit (4) und ein Austrittsgehäuse einer Flüssigkeit (5) umfasst, wobei das mechanische Haltemittel durch den Zusammenbau der Eintritts- und Austrittsgehäuse von Flüssigkeit (4, 5) mit dem Heizelement (7a, 7b) und dem Träger einer elektrischen Karte (13) gebildet ist.

6. Heizvorrichtung nach einem der Ansprüche 1 bis 5, **dadurch gekennzeichnet, dass** der elektrische Verbinder (22b; 23) eine Anschlussfläche aufweist, die sich im Wesentlichen teilweise an den Umfang des Heizelements (7a, 7b) anlegt.

7. Heizvorrichtung nach Anspruch 6, **dadurch gekennzeichnet, dass** das Heizelement (7a, 7b) im Wesentlichen zylindrisch ist, und dass der Umfang des Heizelements (7a, 7b) im Wesentlichen zylindrisch ist.

8. Heizvorrichtung nach Anspruch 1 oder 2 oder nach einem der Ansprüche 5 bis 7, **dadurch gekennzeichnet, dass** sie zwei Heizelemente (7a, 7b) umfasst, und dass das Anschlussmittel einen einzigen elektrischen Verbinder (24) umfasst.

9. Heizvorrichtung nach Anspruch 8, **dadurch gekennzeichnet, dass** die Heizelemente (7a, 7b) im Wesentlichen zylindrisch sind und nebeneinander angeordnet sind, und dass der elektrische Verbinder (24) eine Anschlussfläche (24a) aufweist, die sich im Wesentlichen teilweise an den zylindrischen Umfang des ersten Heizelements (7a) und teilweise an den zylindrischen Umfang des zweiten Heizelements (7b) anlegt, wobei sich der elektrische Verbinder (24) zwischen den Heizelementen (7a, 7b) erstreckt.

10. Heizvorrichtung nach einem der Ansprüche 1 bis 9, **dadurch gekennzeichnet, dass** der Träger einer Karte einer elektrischen Schaltung (13) von elektrischen Kontakten (19a, 19b, 19c, 19d) des elektrischen Verbinders (16) durchquert wird.

11. Heizvorrichtung nach Anspruch 10, **dadurch gekennzeichnet, dass** die elektrischen Kontakte (19a, 19b, 19c, 19d) auf einer Seite des Trägers einer elektrischen Schaltung (13) gegenüber jener, die dem Heizelement (7a, 7b) gegenüberliegt, befestigt sind.

12. Heizvorrichtung nach Anspruch 11, **dadurch gekennzeichnet, dass** das mechanische Haltemittel Verriegelungsclips (20) umfasst, die durch elastische Verformung mit dem Träger einer elektrischen Schaltung (13) zusammenwirken, um den elektrischen Kontakt zwischen den elektrischen Kontakten (19a, 19b, 19c, 19d) und dem Träger einer elektrischen Schaltung (13) zu gewährleisten.

13. Heizvorrichtung nach Anspruch 10, **dadurch gekennzeichnet, dass** der Träger einer elektrischen Karte (13) Öffnungen (15a, 15b, 15c, 15d) aufweist, die mit Kontaktbereichen versehen sind, und dass die elektrischen Kontakte (19a, 19b, 19c, 19d) elastische Stifte (21) umfassen, die in die Öffnungen (15a, 15b, 15c, 15d) des Trägers einer elektrischen Karte (13) eingefügt sind, wobei das Zusammenwirken der elastischen Stifte (21) in den Öffnungen (15a, 15b, 15c, 15d) ein mechanisches Haltemittel bildet.

## Claims

1. Electric fluid-heating device for a motor vehicle, **characterized in that** it comprises:
- at least one heating element (7a, 7b),
- a control means (3) for controlling the heating element (7a, 7b) comprising an electric board support (13), and
- a connection means comprising:
- an electrical connector (22; 16; 23; 24) electrically connecting the heating element (7a, 7b) to the electric board support (13), and
- at least one mechanical retention means configured to mechanically retain the said electrical connector (22; 16; 23, 24) against the heating element (7a, 7b),
**characterized in that** the said at least one heating element (7a, 7b) on its external surface comprises a heating resistance.

2. Heating device according to Claim 1, **characterized in that** the mechanical retention means is removable.

3. Heating device according to one of Claims 1 and 2, **characterized in that** the electrical connector (22) comprises a first connector (22a) electrically connected to the heating element (7a, 7b) and a second connector (22b) electrically connected to the electric circuit board support (13) and **in that** the mechanical retention means is formed by mechanical collaboration between the first and second connectors (22a, 22b).

4. Heating device according to Claim 3, **characterized in that** the first and second connectors can be plugged in one into the other.

5. Heating device according to one of Claims 1 and 2, **characterized in that** the electrical connector (22b, 23) has elastic contact blades configured to make contact with the electrical tracks of the heating element (7a, 7b) and **in that** the heating device comprises a fluid inlet housing (4) and a fluid outlet housing (5) and the mechanical retention means being formed by assembling the fluid inlet and outlet housings (4, 5) with the heating element (7a, 7b) and the electric board support (13).

6. Heating device according to any one of Claims 1 to 5, **characterized in that** the electrical connector (22b; 23) has a connection surface that substantially partially conforms to the periphery of the heating element (7a, 7b).

7. Heating device according to Claim 6, **characterized in that** the heating element (7a, 7b) is substantially cylindrical and **in that** the periphery of the heating element (7a, 7b) is substantially cylindrical.

8. Heating device according to Claim 1 or 2 or according to any one of Claims 5 to 7, **characterized in that** it comprises two heating elements (7a, 7b) and **in that** the connection means comprises a single electrical connector (24).

9. Heating device according to Claim 8, **characterized in that** the heating elements (7a, 7b) are substantially cylindrical and are arranged side by side and **in that** the electrical connector (24) has a connection surface (24a) that substantially partially conforms to the cylindrical periphery of the first heating element (7a) and partially conforms to the cylindrical periphery of the second heating element (7b), the said electrical connector (24) extending between the said heating elements (7a, 7b).

10. Heating device according to any one of Claims 1 to 9, **characterized in that** the electric circuit board support (13) has electrical contacts (19a, 19b, 19c, 19d) of the electrical connector (16) passing through it.

11. Heating device according to Claim 10, **characterized in that** the electrical contacts (19a, 19b, 19c, 19d) are fixed on one face of the electric circuit support (13) that is the opposite face to the face facing the heating element (7a, 7b).

12. Heating device according to Claim 11, **characterized in that** the mechanical retention means comprises locking clips (20) collaborating through elastic deformation with the electric circuit support (13) to ensure electrical contact between the electrical contacts (19a, 19b, 19c, 19d) and the electric circuit support (13).

13. Heating device according to Claim 10, **characterized in that** the electric board support (13) has orifices (15a, 15b, 15c, 15d) provided with contact areas and **in that** the electrical contacts (19a, 19b, 19c, 19d) comprise elastic male members (21) shrink-fitted into the said orifices (15a, 15b, 15c, 15d) of the electric board support (13), collaboration between the elastic male members (21) and the orifices (15a, 15b, 15c, 15d) into which they are inserted forming a means of mechanical retention.
